# EUROPEAN PATENT APPLICATION

(11) **EP 4 739 069 A2**
(43) Date of publication of application: **06.05.2026**
(21) Application number: 25211591.0
(22) Date of filing: 28.10.2025
(51) Int. Cl.: H10W 70/63, H10W 70/685, H10W 70/692

(54) **PACKAGING SUBSTRATE**

(30) Priority: 31.10.2024 US 202463714151 P; 31.10.2024 US 202463714153 P
(71) Applicant: Absolics Inc., Covington, GA 30014 (US)
(72) Inventor: KIM, Sungjin, Covington, Georgia, 30014 (US); KIM, Jincheol, 18469 Hwaseong-si, Gyeonggi-do (KR)
(74) Representative: BCKIP Part mbB

(57) **Abstract**

A packaging substrate according to the embodiment comprises: a glass core; a wiring layer; and an insulating layer. A measurement point is a point on the surface of the packaging substrate, and ten different measurement points are disposed on the surface. The measurement points are spaced apart by at least 0.05 times the surface length. Er is a value of extreme surface reduced modulus (unit: GPa) measured at the measurement point using a nanoindentation method, Er_av is the average of the extreme surface reduced modulus values measured at the measurement points, and Er_stdev is the standard deviation thereof. The ratio of Er_stdev to Er_av may be 7% or less. The packaging substrate according to the embodiment can reduce overall stress by adjusting variations in the extreme surface modulus according to in-plane location within a certain range.

## Description

This application claims priorities of U.S. Provisional Patent Application No. 63/714,151 and, filed on October 31, 2024, and U.S. Provisional Patent Application No. 63/714,153, filed on October 31, 2024.

### BACKGROUND

### TECHNICAL FIELD

The embodiment relates to a packaging substrate in which properties such as extreme surface reduced modulus are controlled. The embodiment relates to a packaging substrate having controlled loss modulus, hardness, and the like.

### DESCRIPTION OF RELATED ART

In the manufacturing of electronic components, the process of forming circuits on a semiconductor wafer is referred to as a front-end (FE) process, and the process of assembling the wafer into a state usable in actual products is referred to as a back-end (BE) process, wherein a packaging process is included in the back-end process.

The four core technologies of the semiconductor industry, which have enabled the rapid development of electronic products in recent years, are semiconductor technology, semiconductor packaging technology, manufacturing process technology, and software technology. Although semiconductor technology has advanced in various forms such as sub-micron or nanometer-scale line widths, integration of more than ten million cells, high-speed operation, and significant heat generation, the technology to perfectly package such devices has not been sufficiently established. Accordingly, the electrical performance of a semiconductor may be determined not by the performance of the semiconductor technology itself, but by the packaging technology and the resulting electrical connection.

Materials used for packaging substrates include ceramics or resins. In the case of ceramic substrates, due to their high resistivity or high dielectric constant, it is not easy to mount high-performance, high-frequency semiconductor elements. In the case of resin substrates, although high-performance, high-frequency semiconductor elements can be mounted relatively easily, there are limitations in reducing the wiring pitch.

Recently, studies applying glass substrates as high-end packaging substrates have been conducted. By forming through-holes in a glass substrate and applying conductive material in the through-holes, the wiring length between the device and the motherboard can be shortened, and excellent electrical characteristics can be obtained.

Related arts include Korean Patent Publication No. 10-2020-0030430 and Korean Patent Publication No. 10-2023-0145447.

### SUMMARY

In some embodiments, a packaging substrate with improved reliability by controlling properties such as extreme surface reduced modulus is provided.

In some embodiments, a packaging substrate in which the loss modulus, hardness, and the like are simultaneously controlled is provided.

According to the embodiments, a packaging substrate includes: a glass core, a wiring layer, and an insulating layer. The glass core is a plate-shaped glass in which vias are arranged, the wiring layer is an electrically conductive layer disposed on a surface of the glass core, and the insulating layer is a layer disposed in the spaces between the electrically conductive layers and includes a mixture of a polymer resin and insulating particles.

The packaging substrate has a top surface on which an electronic component is mounted and a bottom surface opposite thereto. A measurement point is a point on the surface of the packaging substrate, and ten measurement points are arranged on the surface with each having a spacing of at least 0.05 times the total surface length from each other. The measurement is performed at 27°C.

Er is the value of extreme surface reduced modulus (unit: GPa) measured at each measurement point using a nanoindentation method.

Er_av is the average of the extreme surface reduced modulus values measured at the measurement points.

Er_stdev is the standard deviation of the extreme surface reduced modulus values measured at the measurement points.

The packaging substrate may have a ratio of Er_stdev to Er_av of 7% or less.

The difference between the maximum and minimum Er values among those measured at the individual measurement points may be 4 GPa or less.

The surface is the exposed surface of the insulating layer, and the maximum Er value of the insulating layer may be 22 GPa or less.

The insulating layer disposed above the glass core is an upper insulating layer, and a cover layer may be further disposed on the upper insulating layer.

The cover layer may be a polymer resin layer or an insulating inorganic layer.

The surface is the exposed surface of the cover layer, and the maximum Er value of the cover layer may be 16 GPa or less.

The insulating layer disposed below the glass core is a lower insulating layer, and a solder resist layer may be further disposed below the lower insulating layer.

The surface is the exposed surface of the solder resist layer, and the maximum Er value of the solder resist layer may be 21 GPa or less.

The Er_stdev of the packaging substrate may be 1 GPa or less.

The Er_av of the packaging substrate may be 20 GPa or less.

In the nanoindentation method, a Berkovich-type diamond tip indenter is pressed into the measurement point with a maximum load of 25 mN, and Dep-max is the maximum depth measured at the measurement point.

The average value of Dep-max of the packaging substrate may be 1,000 nm or more.

In the nanoindentation method, a Berkovich-type diamond tip indenter is pressed into the measurement point with a maximum load of 25 mN, and Dep_con is the contact depth measured at the measurement point.

The average value of Dep_con of the packaging substrate may be 1,000 nm or less.

The packaging substrate may have a thickness of 500 µm or more.

According to the embodiments, a packaging substrate includes: a glass core, a wiring layer, and an insulating layer. The glass core is a plate-shaped glass in which vias are arranged, the wiring layer is an electrically conductive layer disposed on a surface of the glass core, and the insulating layer is a layer disposed in the spaces between the electrically conductive layers and includes a mixture of a polymer resin and insulating particles.

The average storage modulus (E') of the packaging substrate at a temperature of 20°C or more and less than 30°C is referred to as E'20, and the average storage modulus (E') at a temperature of 140°C or more and less than 150°C is referred to as E'140.

E'20 - E'140 of the packaging substrate may be 80 MPa or less.

The loss modulus (E") of the packaging substrate at 30°C may be 5 MPa or more.

The extreme surface hardness (HIT), measured at any one point on an upper surface or a lower surface of the packaging substrate, may be less than 1 GPa.

The tan delta value of the packaging substrate at 30°C may be 0.009 or less.

The contact compliance of the packaging substrate may be 12 nm/mN or less.

In a nanoindentation test, when a Berkovich-type diamond tip indenter is pressed into the measurement point under a maximum load of 25 mN, Dep-max is the measured maximum depth, and Dep_con is the contact depth measured at the measurement point.

In the packaging substrate, the difference between the Dep-max and the Dep_con may be 220 nm or less.

The insulating layer disposed on the upper portion of the glass core is an upper insulating layer, and a cover layer may additionally be disposed on the upper portion of the upper insulating layer.

The cover layer may comprise a polymer resin or an insulating inorganic layer.

The insulating layer disposed on the lower portion of the glass core is a lower insulating layer, and a solder resist layer may additionally be disposed beneath the lower insulating layer.

The extreme surface hardness (HIT) of the cover layer and the extreme surface hardness (HIT) of the solder resist layer may both be 0.3 GPa or more.

The extreme surface hardness (HIT) of the solder resist layer may be greater than that of the cover layer.

A measurement point is a point on the surface of the packaging substrate, and ten distinct measurement points are disposed on the surface, with each measurement point being spaced apart by at least 0.05 times the diameter or diagonal length of the packaging substrate.

HIT is the extreme surface hardness (unit: GPa) measured at the measurement point using a nanoindentation method, and HIT_stdev is the standard deviation of the extreme surface hardness values measured at the measurement points.

The HIT_stdev of the packaging substrate may be 0.1 GPa or less.

The extreme surface hardness (HIT) of the solder resist layer may be 0.8 GPa or more.

### DESCRIPTION OF THE EMBODIMENTS

The following embodiments are explained in detail with reference to the accompanying drawings, so that those skilled in the art may readily practice the invention. Nevertheless, the invention may be embodied in various forms and is not confined to the specific examples provided herein. Throughout the specification, like reference numerals indicate like elements.

In this specification, the phrase "combinations thereof," when used in a Markush grouping, refers to any mixture or combination containing at least one of the components listed in the group.

The terms "first," "second," "A," "B," and similar designations appearing in this specification are used solely to distinguish between elements bearing the same name. Unless the context expressly dictates otherwise, terms in the singular are to be construed as encompassing the plural.

In this specification, the expression "~-based" denotes a compound that contains the referenced component or a derivative thereof.

As used herein, the phrase "B is located on A" encompasses both situations in which B directly contacts A and situations in which one or more intervening layers are interposed between them; accordingly, it should not be construed as requiring direct contact with the surface of A.

As used herein, the phrase "B is connected to A" embraces both direct connections between A and B and connections made through one or more intermediate components, unless expressly stated otherwise; it should therefore not be construed as requiring a direct link.

Unless the context clearly requires otherwise, terms expressed in the singular throughout this specification are intended to encompass both singular and plural forms.

In the present specification, the expression that A and B are adjacent means that A and B are either in contact with each other or positioned near each other without necessarily being in contact, and unless otherwise specified, shall not be interpreted as being limited to direct contact.

Unless otherwise stated, the physical property values of the respective components of the packaging substrate in the present specification shall be understood as measured at room temperature, which is defined as 20°C to 25°C.

The packaging substrate may have various structures in which wiring layers, insulating layers, cover layers, solder resist layers, and the like are stacked in multiple layers on the upper or lower surface depending on the design. The height of the wiring layers or insulating layers disposed on the packaging substrate may also vary. Despite such design changes, the glass core functions as the support of the packaging substrate, and the wiring layers and insulating layers on the upper and lower surfaces must be stably processed, and the manufactured packaging substrate must operate reliably.

Various attempts have been made to suppress the occurrence of breakage in glass cores. Through such efforts, the inventors recognized that when the extreme surface reduced modulus measured at the surface of a packaging substrate during or after manufacturing is controlled to a certain level or lower, the defect rate decreases and product reliability improves, and this is described in detail herein.

As the glass core, glass for semiconductors (glass substrate) is used. Compared to sapphire substrates, it is less expensive and easier to produce in large sizes, making it commercially advantageous. Compared to semiconductor inorganic substrates such as silicon, it has properties of an insulator. This allows a packaging substrate applying a glass core to achieve better power efficiency and stability at higher frequencies.

Despite the excellent properties of the glass core, it has the disadvantage of poor workability due to the inherent brittleness of glass. A glass core having through-hole and/or cavity-type structures formed in brittle glass is vulnerable to breakage during the manufacturing process. The redistribution layer formation process involves multiple steps including heating and cooling, which applies stress to the glass core. This stress may accumulate in the glass core as so-called residual stress. The glass core undergoes several processes including transportation and storage, during which even minimal vibration or shock may be inevitably applied. This may lead to breakage of the glass core.

For example, during the manufacturing process of the packaging substrate, cracking referred to as "SeWaRe" may occur. While various opinions exist regarding the cause, it is presumed that stress applied to the glass by the upper or lower layers is a primary factor. To reduce such stress, materials having a low storage modulus and high loss modulus may be applied. However, the packaging substrate must still maintain hardness above an appropriate level. The inventors propose a packaging substrate that can maintain excellent surface hardness while reducing stress applied to the glass core.

In the following description, the packaging substrate in the embodiment may be in a singulated state. Alternatively, the packaging substrate may be a strip substrate in which multiple individual packaging substrates are arranged with dummy regions interposed therebetween; a quad substrate in which dummy regions are arranged between a plurality of the strip substrates; or a panel substrate in which dummy regions are arranged between a plurality of the quad substrates. For convenience of description, all of these will be collectively referred to as the packaging substrate.

Hereinafter, the embodiment will be described in more detail.

To achieve the above object, a packaging substrate according to one embodiment comprises a glass core, a wiring layer, and an insulating layer.

The glass core is a plate-shaped glass having vias.

The wiring layer is an electrically conductive layer disposed on the surface of the glass core. The wiring layer may be disposed in a predetermined pattern. The wiring layer comprises both a circuit layer connected in a planar direction and through-electrodes connected in a vertical direction.

The insulating layer is a layer having electrical insulation properties and disposed in the space between the electrically conductive layers. The insulating layer may be a layer comprising a mixture of a polymer resin and insulating particles. For example, an Ajinomoto Build-up Film (ABF) manufactured by Ajinomoto Co., Inc. may be applied, but is not limited thereto.

The packaging substrate has a top surface on which an electronic component is mounted, and/or a bottom surface opposite thereto.

The insulating layer disposed above the glass core is referred to as an upper insulating layer. The wiring layer may be partially or entirely embedded within the upper insulating layer.

The insulating layer disposed below the glass core is referred to as a lower insulating layer. The wiring layer may be partially or entirely embedded within the lower insulating layer.

The packaging substrate may further comprise a cover layer disposed on the upper insulating layer.

The cover layer may be, for example, a polymer insulating layer such as a polyimide layer, or an inorganic insulating layer such as a silica layer, but is not limited thereto.

The packaging substrate may further comprise a solder resist layer disposed below the lower insulating layer.

The solder resist layer may be, for example, a solder resist or a composition for a solder mask.

The inventors measured an extreme surface reduced modulus (Reduced Modulus, hereinafter referred to as "Er") at the surface of the packaging substrate. The Er may be measured using a nanoindentation method.

The specific nanoindentation measurement method and conditions will be described later.

Nanoindentation is a technique for measuring the physical properties of a material by continuously recording the load and penetration depth as a predetermined geometric indenter is pressed into and withdrawn from the surface of the target, and analyzing the resulting load-displacement curve. The method focuses on plastic deformation that occurs during indentation and allows for nondestructive evaluation of mechanical properties in relatively thin layers.

The inventors determined that the nanoindentation method allows for reliable measurement of the physical properties of each layer formed during the manufacturing process of the packaging substrate, since it measures the properties of localized surface regions.

The physical property of the packaging substrate is measured at a measurement point.

The measurement point is a point on the surface of the packaging substrate.

The surface having measurement points arranged thereon is selected from among the surface of the insulating layer, the surface of the cover layer, and the surface of the solder resist layer.

A plurality of measurement points are arranged on the surface, and, for example, ten measurement points are used for measurement.

The measurement points are arranged at intervals on the surface. For example, the measurement may be conducted at ten measurement points arranged with a spacing of 0.05 times or more the surface length of the packaging substrate. The measurement may also be conducted at ten measurement points arranged with a spacing of 0.2 times or less the surface length.

The surface length refers to the longest dimension of the surface of the packaging substrate. For example, if the packaging substrate is rectangular, the diagonal length is the surface length. If the packaging substrate is circular, the surface length is the diameter. If the packaging substrate has an irregular or modified rectangular shape, the longest measurable length of the surface is considered the surface length. When the physical properties of the surface are measured at multiple measurement points in this way, it is possible to evaluate not only the physical properties at each individual measurement point but also the differences in physical properties between the respective measurement points.

At the measurement point, the physical property is measured regardless of whether any structure exists below the surface. This relates to the fact that, regardless of the design shape of the pattern or whether a separate component is disposed in a cavity within the glass core, the stress within the packaging substrate should be controlled to a certain level or lower.

The nanoindentation measurement at the measurement point may be based on the ISO 14577 standard. The measurement is based on application of a maximum load of 25 mN using a Berkovich-type diamond tip indenter. For example, the measurement equipment may be the NanoTest Vantage Platform (MICRO MATERIALS), and the measurement values may be calculated using software provided by the manufacturer. In this case, the tip sharpness may be approximately 56.36 nm, and the effective radius may be approximately 68.67 ± 1.48 nm. The measurement is conducted at a temperature of approximately 27°C and a relative humidity of approximately 25%.

The representative physical property confirmed by the above measurement is the reduced modulus. Since the modulus is measured at the surface by an indentation method, it is referred to as Er (extreme surface reduced modulus).

Er is an extreme surface reduced modulus (unit: GPa) measured at each individual measurement point.

Er_av is an average (unit: GPa) of the extreme surface reduced modulus values measured at the ten measurement points. The average may be obtained using the AVERAGE function of Microsoft Excel.

Er_stdev is a standard deviation (unit: GPa) of the extreme surface reduced modulus values measured at the ten measurement points. The standard deviation may be obtained using the STDEV.S function of Microsoft Excel.

The packaging substrate according to the embodiment may have an Er_stdev to Er_av ratio of 7% or less. The ratio may be 6.5% or less, 6.0% or less, 5.5% or less, or 5.0% or less. The ratio may be 0.5% or more, 1.0% or more, or 1.5% or more. The ratio is calculated based on the extreme surface reduced modulus values in GPa.

A packaging substrate having such characteristics may exhibit small variation in the extreme surface reduced modulus values across the entire surface. The packaging substrate may have relatively uniform properties over the entire area, and may improve impact resistance and workability.

Er_av of the packaging substrate may be 20 GPa or less. Er_av may be 19.6 GPa or less, 19.2 GPa or less, or 18.8 GPa or less. Er_av may be 13 GPa or more, or 14 GPa or more. A packaging substrate having such an Er_av may have a relatively low modulus, thereby substantially reducing the stress applied to the packaging substrate.

Er_stdev of the packaging substrate may be 1 GPa or less. Er_stdev may be 0.95 GPa or less, 0.90 GPa or less, or 0.85 GPa or less. Er_stdev may be 0.3 GPa or more, or 0.5 GPa or more. A packaging substrate having such an Er_stdev may have relatively small differences in modulus values across the surface, enabling manufacture of a packaging substrate having uniform stress and physical properties overall.

The difference between the maximum and minimum Er values measured at the individual points on the same surface may be 4 GPa or less. The difference may be 3.8 GPa or less, 3.4 GPa or less, 3.0 GPa or less, or 2.7 GPa or less. The difference may be 0.5 GPa or more, or 1.0 GPa or more. A packaging substrate having such characteristics may have small differences in modulus values on the surface, thereby improving impact resistance.

The surface may be a surface where the insulating layer is exposed. The insulating layer is applied during the process of forming redistribution wiring. The insulating layer may be one layer, or may comprise two or more, three or more, or four or more layers with wiring layers interposed therebetween. The insulating layer may comprise up to 25 layers. Regardless of the number of layers, the insulating layer may have the following characteristics.

The maximum value among the Er values of the insulating layer surface may be 22 GPa or less. The maximum value may be 21 GPa or less, or 20 GPa or less. The maximum value may be 17 GPa or more, or 18 GPa or more. An insulating layer having such a low Er value may have relatively flexible characteristics, which can help keep the stress applied to the glass core within a certain range during repeated heating and cooling cycles in the manufacturing process.

Er_av of the insulating layer surface may be 20 GPa or less, or 19 GPa or less. Er_av may also be 14 GPa or more, or 16 GPa or more.

Er_stdev of the insulating layer surface may be 0.9 GPa or less, or 0.8 GPa or less. Er_stdev may be 0.6 GPa or more, or 0.7 GPa or more.

The difference between the maximum and minimum Er values of the insulating layer surface may be 4.5 GPa or less, or 3.5 GPa or less. The difference may be 0.5 GPa or more, or 1.5 GPa or more.

At the surface of the insulating layer, the ratio of Er_stdev to Er_av may be 6% or less, or 5% or less. The ratio may be 3% or more, or 4% or more.

An insulating layer having such physical properties may have an appropriate level of modulus and in-plane distribution characteristics, thereby improving workability during packaging substrate fabrication and maintaining impact resistance at or above a certain level.

The surface may be a surface where the cover layer is exposed.

The maximum Er value at the surface of the cover layer may be 16 GPa or less. The maximum value may be 15.5 GPa or less, or 15 GPa or less. The maximum value may be 12 GPa or more, or 13 GPa or more. A cover layer having such a low Er value may have relatively flexible characteristics, which can help maintain the stress generated in the glass core at or below a certain level during repeated heating and cooling cycles in the packaging substrate manufacturing process.

Er_av at the surface of the cover layer may be 16 GPa or less, or 15 GPa or less. Er_av may also be 12 GPa or more, or 13 GPa or more.

Er_stdev at the surface of the cover layer may be 1 GPa or less, or 0.9 GPa or less. Er_stdev may also be 0.6 GPa or more, or 0.7 GPa or more.

The difference between the maximum and minimum Er values at the surface of the cover layer may be 4.5 GPa or less, or 3.5 GPa or less. The difference may be 0.5 GPa or more, or 1.5 GPa or more.

At the surface of the cover layer, the ratio of Er_stdev to Er_av may be 7% or less, or 6.5% or less. The ratio may be 3% or more, or 4% or more.

A cover layer having such physical properties may have an appropriate level of modulus and in-plane distribution characteristics, thereby improving workability during packaging substrate fabrication and maintaining impact resistance at or above a certain level.

The surface may be a surface where the solder resist layer is exposed.

The maximum Er value at the surface of the solder resist layer may be 22 GPa or less. The maximum value may be 21.5 GPa or less, or 21 GPa or less. The maximum value may be 17 GPa or more, or 18 GPa or more. A solder resist layer having such a low Er value may have relatively flexible characteristics, which can help maintain the stress generated in the glass core at or below a certain level during repeated heating and cooling cycles in the packaging substrate manufacturing process.

Er_av at the surface of the solder resist layer may be 21 GPa or less, or 20 GPa or less. Er_av may also be 17 GPa or more, or 18 GPa or more.

Er_stdev at the surface of the solder resist layer may be 0.7 GPa or less, or 0.6 GPa or less. Er_stdev may be 0.2 GPa or more, or 0.3 GPa or more.

The difference between the maximum and minimum Er values at the surface of the solder resist layer may be 2.5 GPa or less, or 2 GPa or less. The difference may be 0.5 GPa or more, or 1 GPa or more.

At the surface of the solder resist layer, the ratio of Er_stdev to Er_av may be 5% or less, or 4% or less. The ratio may be 1% or more, or 2% or more.

A solder resist layer having such physical properties may have an appropriate level of modulus and in-plane distribution characteristics, thereby improving workability during packaging substrate fabrication and maintaining impact resistance at or above a certain level.

The packaging substrate may have a thickness of 500 µm or more. The thickness of the packaging substrate may be 550 µm or more, 600 µm or more, or 650 µm or more. The thickness may be 5,000 µm or less, 4,000 µm or less, 3,000 µm or less, or 1,000 µm or less.

The thickness of the glass core may be 300 µm or more. The thickness of the glass core may be 350 µm or more, 400 µm or more, or 450 µm or more. The thickness of the glass core may be 2,000 µm or less, or 1,000 µm or less.

The nanoindentation method may be a method in which a Berkovich-type diamond tip indenter is pressed into the measurement point at a maximum load of 25 mN. In this case, Dep-max is the maximum depth measured at the measurement point. Also, Dep_con is the contact depth measured at the measurement point.

The average value of Dep-max may be 1,000 nm or more. The average value may be 1,500 nm or less. In such a case, it is considered that the extreme surface reduced modulus value of the packaging substrate can be appropriately measured, and suitable for evaluating stress in the packaging substrate.

The average value of Dep_con may be 1,000 nm or less. The average value may be 600 nm or more. In such a case, it is considered that the packaging substrate may have stress within a controlled range.

A packaging substrate with improved reliability through control of extreme surface reduced modulus and the like may involve various factors during the manufacturing process. For example, such control may be achieved by adjusting the heating and cooling process during fabrication of each layer, and by selectively applying low-modulus compositions for the insulating layer, cover layer, and/or solder resist layer.

In addition, when the surface properties described above are observed during the manufacturing process, the process may be halted before proceeding to the next step, and additional stress-relief measures may be taken. Such a method may improve the workability and efficiency of the manufacturing process.

The extreme surface hardness (HIT) may be measured by a nanoindentation method.

The nanoindentation method is based on pressing a Berkovich-type diamond tip indenter into the measurement point under a maximum load of 25 mN. As an example, the measurement equipment may be a NanoTest Vantage Platform (MICRO MATERIALS), and the measurement values may be derived using software provided by the manufacturer. In this case, the tip sharpness of the indenter may be approximately 56.36 nm, and the effective radius may be approximately 68.67 ± 1.48 nm. The measurements may be taken at a temperature of approximately 27°C and a relative humidity of approximately 25%.

Unless otherwise stated, the nanoindentation results are based on the average value measured at 10 measurement points.

A measurement point refers to a point on the surface of the packaging substrate, and ten distinct measurement points are disposed on the surface. The measurement points are spaced at least 0.05 times the diameter or diagonal length of the packaging substrate.

The measurement using the nanoindentation method may comply with ISO 14577 standards.

HIT refers to the extreme surface hardness (unit: GPa) measured by the nanoindentation method at the measurement point.

The extreme surface hardness (HIT) measured at any point on the upper or lower surface of the packaging substrate may be less than 1 GPa. The extreme surface hardness (HIT) may be 0.9 GPa or less, or 0.8 GPa or less. The extreme surface hardness (HIT) may be 0.6 GPa or more, or 0.7 GPa or more. When the HIT falls within this range, a packaging substrate with appropriate processability may be obtained.

HIT_stdev refers to the standard deviation of the extreme surface hardness values measured at the measurement points. HIT_stdev of the packaging substrate may be 0.1 GPa or less. HIT_stdev may be 0.08 GPa or less, 0.06 GPa or less, or 0.05 GPa or less. HIT_stdev may be 0.005 GPa or more. When the standard deviation of the HIT is minimal, a packaging substrate having overall stable physical properties regardless of the internal structure may be provided. The standard deviation may be calculated using the STDEV.S function of the Microsoft Excel program.

The extreme surface hardness (HIT) of the solder resist layer may be greater than the extreme surface hardness (HIT) of the cover layer. In such a case, the fabricated packaging substrate may have improved durability.

The extreme surface hardness (HIT) of the cover layer and the solder resist layer may both be 0.3 GPa or more. In this case, each surface may have the minimum required surface hardness, thereby enabling the packaging substrate to have processability above a suitable level. The extreme surface hardness (HIT) of the cover layer and the solder resist layer may both be 0.4 GPa or more, 0.5 GPa or more, or 0.6 GPa or more. The extreme surface hardness (HIT) of both the cover layer and the solder resist layer may be 1.5 GPa or less.

The extreme surface hardness (HIT) of the solder resist layer may be 0.8 GPa or more, and may also be 1.5 GPa or less or 1.2 GPa or less.

The extreme surface hardness (HIT) of the cover layer may be 0.6 GPa or more, and may also be 1.2 GPa or less or 0.8 GPa or less.

Dep-max is the maximum depth measured by indentation at the measurement point using a nanoindentation method, and Dep_con is the contact depth measured at the measurement point using the nanoindentation method.

The difference between Dep-max and Dep_con may be 220 nm or less. The difference may be 200 nm or less, 180 nm or less, or 170 nm or less. The difference may be 140 nm or more. This difference is believed to relate to the lateral force (x-y direction) applied to the tip of the indenter during indentation at the measurement point. That is, the phenomenon known as SeWaRe (cracking of the glass core) is believed to be associated with this lateral stress. When the difference is within the above range, the occurrence of glass core cracking due to such stress may be reduced, thereby improving processability.

The average value of Dep-max may be 1,000 nm or more. The average value may be 1,500 nm or less. In this case, the extreme surface reduced modulus of the packaging substrate can be measured appropriately for stress evaluation.

The average value of Dep_con may be 1,000 nm or less. The average value may be 600 nm or more. In this case, it is considered that the packaging substrate may have stress within a controlled range.

The contact compliance of the packaging substrate may be 12 nm/mN or less. The contact compliance may be 11 nm/mN or less, 10 nm/mN or less, or 9 nm/mN or less. The contact compliance may be 6 nm/mN or more. A packaging substrate having such contact compliance may exhibit improved processability.

A storage modulus and a loss modulus may be measured using a Dynamic Mechanical Analyzer (DMA). Hereinafter, the measurement values by the DMA refer to values measured at a frequency of 1 Hz.

The average storage modulus (E') at a temperature from 20°C to less than 30°C is referred to as E'20. The average storage modulus (E') at a temperature from 140°C to less than 150°C is referred to as E'140. The average storage modulus (E') at a temperature from 110°C to less than 120°C is referred to as E'110.

E'20 - E'140 of the packaging substrate may be 80 MPa or less. E'20 - E'140 of the packaging substrate may be 70 MPa or less, 60 MPa or less, or 50 MPa or less. E'20 - E'140 of the packaging substrate may be 30 MPa or more or 40 MPa or more. A packaging substrate having such characteristics may provide relatively low stress even under repeated ambient temperature changes, thereby reducing the probability of damage during the manufacturing process.

E'20 - E'110 of the packaging substrate may be 60 MPa or less. E'20 - E'110 of the packaging substrate may be 55 MPa or less, 45 MPa or less, 35 MPa or less, 25 MPa or less, or 20 MPa or less. E'20 - E'110 of the packaging substrate may be 5 MPa or more or 10 MPa or more. A packaging substrate having such characteristics may provide relatively low stress even under repeated ambient temperature changes, thereby reducing the probability of damage during manufacturing or operation.

The average loss modulus (E") at a temperature from 20°C to less than 30°C is referred to as E"20. The average loss modulus (E") at a temperature from 140°C to less than 150°C is referred to as E"140. The average loss modulus (E") at a temperature from 110°C to less than 120°C is referred to as E"110.

E"20 - E"140 of the packaging substrate may be 25 MPa or less. E"20 - E"140 of the packaging substrate may be 22 MPa or less, 20 MPa or less, 18 MPa or less, or 15 MPa or less. E"20 - E"140 of the packaging substrate may be 8 MPa or more or 10 MPa or more. A packaging substrate having such characteristics may provide relatively low stress even under repeated ambient temperature changes, thereby providing a packaging substrate with reduced damage.

E"20 - E"110 of the packaging substrate may be less than 10 MPa. E"20 - E"110 of the packaging substrate may be 9 MPa or less, 8 MPa or less, or 7 MPa or less. E"20 - E"110 of the packaging substrate may be 3 MPa or more or 5 MPa or more. A packaging substrate having such characteristics may exhibit relatively low stress even under repeated ambient temperature changes, thereby providing a packaging substrate with reduced damage.

The storage modulus (E') of the packaging substrate at 30°C may be 850 MPa or less.

The storage modulus (E') of the packaging substrate at 30°C may be 835 MPa or less, or 815 MPa or less. The storage modulus (E') may be 750 MPa or more, or 780 MPa or more. In such cases, the packaging substrate may exhibit a suitable level of rebound force against external impacts applied during manufacturing or transportation, thereby improving processability.

The loss modulus (E") of the packaging substrate at 30°C may be 5 MPa or more.

The loss modulus (E") of the packaging substrate at 30°C may be 5.5 MPa or more, or 6.0 MPa or more. The loss modulus (E") may be 8 MPa or less, or 7 MPa or less. In such cases, the packaging substrate may exhibit a suitable level of rebound force against external impacts applied during manufacturing or transportation, thereby improving processability.

The difference between the average tan delta value at 140°C to less than 150°C and the average tan delta value at 20°C to less than 30°C may be 0.016 or less.

The difference between the average tan delta value at 110°C to less than 120°C and the average tan delta value at 20°C to less than 30°C may be 0.008 or less.

The average values may be calculated using the AVERAGE function of the Microsoft Excel program.

The tan delta value of the packaging substrate at 30°C may be 0.009 or less, 0.0085 or less, or 0.008 or less.

A packaging substrate having such characteristics may exhibit improved processability.

Hereinafter, the embodiment will be described in more detail through specific examples. The following examples are provided merely to aid understanding of the present invention, and the scope of the invention is not limited thereto.

### Manufacturing Example 1

A laser was irradiated onto a semiconductor glass substrate at predetermined positions for via formation, and etching was subsequently performed. The etching was conducted by immersing the substrate in a mixed solution of 1.8 M hydrofluoric acid and 1.0 M nitric acid for 5 minutes, followed by rinsing with deionized water and neutralizing with a 4.5 mol% sodium bicarbonate solution for 30 seconds.

The glass substrate was dried at 120°C for 30 minutes. Then, titanium (Ti) 50 nm and copper (Cu) 120 nm seed layers were deposited onto predetermined locations on the top, bottom, and via inner surfaces by sputtering. The sputtering was carried out at 100 W under 5 mTorr of argon atmosphere.

On the seed layer, 1.3 µm thick copper wiring layers were electroplated on both top and bottom surfaces using an electrolyte of 0.6 M copper sulfate and 0.2 M sulfuric acid at 25°C, with a current density of 9.2 mA/cm² for 15 minutes.

Thereafter, a 50 µm-thick Ajinomoto Build-up Film (ABF) was applied to form an insulating layer. According to the wiring design, additional Ti (50 nm) and Cu (120 nm) seed layers and Cu (1.5 µm) wiring layers were formed under the same conditions at predetermined positions to complete electrical connections. This process was repeated to form a lower insulating layer including three wiring layers, and an upper insulating layer including six wiring layers, on the bottom and top of the glass core, respectively. The manufactured sample is hereinafter referred to as Sample 1.

### Manufacturing Example 2

In a substrate having a lower insulating layer-glass core-upper insulating layer structure fabricated in the same manner as Sample 1, a protective layer (cover layer) was additionally formed. Specifically, a 10 µm thick polyimide (PI) protective layer was spin-coated on the upper side of the substrate (facing the semiconductor chip mounting surface). Spin coating was performed at 3000 rpm for 30 seconds, followed by a soft bake at 80°C for 10 minutes. Subsequently, a curing process was performed at 350°C for 1 hour, with a ramp-up rate of 4°C/min and a cooling rate of 2°C/min. The resulting sample is hereinafter referred to as Sample 2.

### Manufacturing Example 3

On the lower side (facing the PCB bonding surface) of a substrate having a lower insulating layer-glass core-upper insulating layer-cover layer structure fabricated in the same manner as in Manufacturing Example 2, a solder resist composition was applied by screen printing to a thickness of 10 µm. After printing, preliminary drying was performed at 80°C for 15 minutes. Then, a curing process was carried out at 180°C for 1 hour, with a ramp-up rate of 3°C/min. The substrate with all layers laminated was subjected to thermal treatment in a vacuum atmosphere (10^-3 Torr) at 250°C for 1 hour to complete final bonding and physical property stabilization. During this process, the ramp-up rate was adjusted to 2°C/min, and the cooling rate was adjusted to 1°C/min to minimize thermal stress. The resulting sample is hereinafter referred to as Sample 3.

Finally, the prepared samples were stabilized for 24 hours under environmental conditions of 23 ± 2°C and 50 ± 5% relative humidity before the following test was conducted.

### Evaluation of Physical Properties (1)

The diagonal length of each square sample was measured, and a value corresponding to 1/20 of that length (distance value) was calculated and used as a reference for placement of measurement points. Each square sample was divided into four regions, and two to four measurement points were placed in each region. The distances between points were arranged to satisfy the above distance value condition.

At each measurement point, the extreme surface reduced modulus was measured using a nanoindentation instrument. During measurement, the temperature was approximately 27°C and the relative humidity was approximately 25%. The measurement equipment used was the NanoTest Vantage Platform (MICRO MATERIALS), and a Berkovich-type diamond tip indenter was applied with a maximum load of 25 mN. The tip of the indenter had a sharpness of approximately 56.36 nm and an effective radius of approximately 68.67 ± 1.48 nm. The measured results were input into the software provided by the equipment manufacturer and output as reduced modulus. The results are shown in Tables 1 and 2 below.

**[Table 1]**

| Sample 1 | Max Depth (nm) | Contact Depth (nm) | Maximum Load (mN) | Er: Reduced Modulus (GPa) |
|---|---|---|---|---|
| measurement point 1 | 1207.98 | 1045.6 | 25 | 18.83 |
| measurement point 2 | 1253.33 | 1095.05 | 25 | 18.46 |
| measurement point 3 | 1231.7 | 1074.81 | 25 | 18.97 |
| measurement point 4 | 1178.9 | 1024.92 | 25 | 20.25 |
| measurement point 5 | 1253.96 | 1096.04 | 25 | 18.48 |
| measurement point 6 | 1285.45 | 1125.06 | 25 | 17.74 |
| measurement point 7 | 1226.93 | 1070.02 | 25 | 19.05 |
| measurement point 8 | 1293.76 | 1133.56 | 25 | 17.63 |
| measurement point 9 | 1267.02 | 1108.41 | 25 | 18.2 |
| measurement point 10 | 1241.54 | 1083.3 | 25 | 18.66 |
| Sample 2 | Max Depth(nm) | Contact Depth(nm) | Maximum load(mN) | Er: Reduced Modulus(GPa) |
| measurement point 1 | 1435.19 | 1264.41 | 25 | 14.85 |
| measurement point 2 | 1456.51 | 1286.14 | 25 | 14.63 |
| measurement point 3 | 1446.41 | 1274.21 | 25 | 14.61 |
| measurement point 4 | 1451.49 | 1280.11 | 25 | 14.61 |
| measurement point 5 | 1473.51 | 1299.09 | 25 | 14.15 |
| measurement point 6 | 1441.08 | 1268.92 | 25 | 14.67 |
| measurement point 7 | 1532.47 | 1331.53 | 25 | 11.99 |
| measurement point 8 | 1424.36 | 1257.83 | 25 | 15.3 |
| measurement point 9 | 1452.68 | 1278.82 | 25 | 14.42 |
| measurement point 10 | 1451.42 | 1277.07 | 25 | 14.4 |
| Sample 3 | Max Depth(nm) | Contact Depth(nm) | Maximum load(mN) | Er: Reduced Modulus(GPa) |
| measurement point 1 | 1259.33 | 1103.71 | 25 | 18.63 |
| measurement point 2 | 1222.74 | 1058.35 | 25 | 18.38 |
| measurement point 3 | 1256.35 | 1101.19 | 25 | 18.73 |
| measurement point 4 | 1204.19 | 1046.57 | 25 | 19.38 |
| measurement point 5 | 1164.37 | 1007.77 | 25 | 20.25 |
| measurement point 6 | 1227.92 | 1071.15 | 25 | 19.05 |
| measurement point 7 | 1228.46 | 1070.91 | 25 | 18.96 |
| measurement point 8 | 1207.49 | 1045.82 | 25 | 18.91 |
| measurement point 9 | 1214.39 | 1061.17 | 25 | 19.67 |
| measurement point 10 | 1220.63 | 1063.05 | 25 | 19.09 |

**[Table 2]**

| | Sample 1 | Sample 2 | Sample 3 |
|---|---|---|---|
| Er_av (GPa)* | 18.6300 | 14.3600 | 19.1000 |
| Er_stdev (GPa)* | 0.7450 | 0.888 | 0.5430 |
| Maximum Er Value | 20.25 | 15.3 | 20.25 |
| Difference* | 2.52 | 3.31 | 1.62 |

| | | | |
|---|---|---|---|
| * Er_av refers to the average of the extreme surface reduced modulus values (unit: GPa) measured at each individual measurement point, and was obtained using the AVERAGE function in Microsoft Excel. * Er_stdev refers to the standard deviation of the extreme surface reduced modulus values (unit: GPa) measured at each individual measurement point, and was obtained using the STDEV.S function in Microsoft Excel. * The term "difference" refers to the difference between the maximum and minimum Er values measured at individual measurement points on the same surface. | | | |

When comparing Samples 1 to 3, it was confirmed that Samples 1 and 3 exhibited improved impact and vibration resistance characteristics, resulting in a reduced defect rate due to breakage. This is considered to indicate improved workability and related advantages compared to Sample 2.

**[Table 3]**

| Sample 1 | Max Depth (nm) | Contact Depth (nm) | Differe nce* | Extreme Surface Hardness (HIT, GPa) | Contact Compliance (nm/mN) |
|---|---|---|---|---|---|
| Measurement Point 1 | 1207.9811 | 1045.5973 | 162 | 0.905086 | 8.660472 |
| Measurement Point 2 | 1253.3338 | 1095.0549 | 158 | 0.826307 | 8.441543 |
| Measurement Point 3 | 1231.696 | 1074.807 | 157 | 0.857265 | 8.367417 |
| Measurement Point 4 | 1178.8961 | 1024.9163 | 154 | 0.941405 | 8.212258 |
| Measurement Point 5 | 1253.9558 | 1096.037 | 158 | 0.824848 | 8.422337 |
| Measurement Point 6 | 1285.454 | 1125.0613 | 160 | 0.783423 | 8.55428 |
| Measurement Point 7 | 1226.9298 | 1070.0162 | 157 | 0.864845 | 8.368728 |
| Measurement Point 8 | 1293.7556 | 1133.5579 | 160 | 0.771886 | 8.543877 |
| Measurement Point 9 | 1267.0183 | 1108.413 | 159 | 0.806792 | 8.458951 |
| Measurement Point 10 | 1241.5424 | 1083.2974 | 158 | 0.844075 | 8.439731 |

| Sample 2 | Max Depth (nm) | Contact Depth (nm) | Differe nce* | Extreme Surface Hardness (HIT, GPa) | Contact Compliance (nm/mN) |
|---|---|---|---|---|---|
| Measurement Point 1 | 1435.189 | 1264.4113 | 171 | 0.622191 | 9.108147 |
| Measurement Point 2 | 1456.5106 | 1286.1351 | 170 | 0.601606 | 9.086698 |
| Measurement Point 3 | 1446.4062 | 1274.2108 | 172 | 0.612777 | 9.183761 |
| Measurement Point 4 | 1451.4916 | 1280.1087 | 171 | 0.607213 | 9.140423 |
| Measurement Point 5 | 1473.5055 | 1299.0905 | 174 | 0.589812 | 9.302135 |
| Measurement Point 6 | 1441.0846 | 1268.9225 | 172 | 0.61783 | 9.181981 |
| Measurement Point 7 | 1532.4765 | 1331.534 | 201 | 0.561756 | 10.716935 |
| Measurement Point 8 | 1424.3585 | 1257.8328 | 167 | 0.628634 | 8.881375 |
| Measurement Point 9 | 1452.6797 | 1278.8213 | 174 | 0.608421 | 9.272451 |
| Measurement Point 10 | 1451.4241 | 1277.0683 | 174 | 0.610071 | 9.298978 |

| Sample 3 | Max Depth (nm) | Contact Depth (nm) | Differe nce* | Extreme Surface Hardness (HIT, GPa) | Contact Compliance (nm/mN) |
|---|---|---|---|---|---|
| Measurement Point 1 | 1259.329 | 1103.7095 | 156 | 0.813584 | 8.299712 |
| Measurement Point 2 | 1222.7358 | 1058.3504 | 164 | 0.883727 | 8.767219 |
| Measurement Point 3 | 1256.3536 | 1101.1915 | 155 | 0.817255 | 8.275317 |
| Measurement Point 4 | 1204.1853 | 1046.5682 | 158 | 0.903433 | 8.406241 |
| Measurement Point 5 | 1164.3739 | 1007.7728 | 157 | 0.973195 | 8.352064 |
| Measurement Point 6 | 1227.9209 | 1071.1491 | 157 | 0.863043 | 8.361164 |
| Measurement Point 7 | 1228.4633 | 1070.9059 | 158 | 0.86343 | 8.403068 |
| Measurement Point 8 | 1207.4872 | 1045.8226 | 162 | 0.904702 | 8.622116 |
| Measurement Point 9 | 1214.3933 | 1061.1696 | 153 | 0.879108 | 8.171927 |
| Measurement Point 10 | 1220.6347 | 1063.0481 | 158 | 0.87605 | 8.404617 |

| | | | | | |
|---|---|---|---|---|---|
| * The above difference refers to the difference between the Max Depth and the Contact Depth, and the unit is nm. | | | | | |

**[Table 4]**

| Average | Max Depth (nm) | Contact Depth (nm) | Difference* | Extreme Surface Hardness (HIT, GPa) | Contact Compliance (nm/mN) |
|---|---|---|---|---|---|
| Sample 1 | 1244.0563 | 1085.6758 | 158.38046 | 0.8425932 | 8.4470 |
| Sample 2 | 1456.5126 | 1281.8135 | 174.69912 | 0.6060311 | 9.3173 |
| Sample 3 | 1220.5877 | 1062.9688 | 157.61893 | 0.8777527 | 8.4063 |

| Std. Dev. | Max Depth (nm) | Contact Depth (nm) | Difference* | Extreme Surface Hardness (HIT, GPa) | Contact Compliance (nm/mN) |
|---|---|---|---|---|---|
| Sample 1 | 34.792723 | 33.703344 | 2.2952138 | 0.0524 | 0.1224 |
| Sample 2 | 29.728032 | 20.884774 | 9.5113754 | 0.0189 | 0.5073 |
| Sample 3 | 26.955791 | 27.658289 | 3.2190809 | 0.0456 | 0.1717 |

| | | | | | |
|---|---|---|---|---|---|
| * The above difference refers to the difference between the Max Depth and the Contact Depth, and the unit is nm. | | | | | |

### Property Evaluation (2)

Samples 1 and 3 were measured using a Dynamic Mechanical Analyzer (DMA). The instrument used was the DMA 7100 manufactured by Hitachi, and the measured values were output using software provided by the manufacturer.

Each sample was placed inside the instrument and heated from approximately -40°C to +210°C over about 70 minutes to measure E', E'', and tan delta. The applied frequency was 1 Hz.

**[Table 5]**

| **Sample 1** | **Temperature Range (°C)** | **E'(MPa)** | **E"(MPa)** | **tanD** |
|---|---|---|---|---|
| Section 1 | 20 to <30 | 1,347 | 12.5 | 0.00928 |
| Section 2 | 30 to <40 | 1,338 | 12.67 | 0.00947 |
| Section 3 | 40 to <50 | 1,331 | 13.27 | 0.00997 |
| Section 4 | 50 to <60 | 1,322 | 14.07 | 0.01064 |
| Section 5 | 60 to <70 | 1,312 | 15.17 | 0.01157 |
| Section 6 | 70 to <80 | 1,301 | 16.57 | 0.01275 |
| Section 7 | 80 to <90 | 1,289 | 18.08 | 0.01403 |
| Section 8 | 90 to <100 | 1,277 | 20.02 | 0.01570 |
| Section 9 | 100 to <110 | 1,261 | 20.02 | 0.01570 |
| Section 10 | 110 to <120 | 1,261 | 22.47 | 0.01780 |
| Section 11 | 120 to <130 | 1,243 | 25.44 | 0.02050 |
| Section 12 | 130 to <140 | 1,221 | 28.76 | 0.02358 |
| Section 13 | 140 to <150 | 1,191 | 32.27 | 0.02713 |
| | 30°C | 1,344 | 12.75 | 0.00949 |
| - | Difference (13th - 1st section) | 156 | 20 | 0.01785 |
| - | Difference (10th - 1st section) | 86 | 10 | 0.00854 |

| Sample 3 | Temperature Range (°C) | E'(MPa) | E"(MPa) | tanD |
|---|---|---|---|---|
| Section 1 | 20 to <30 | 807 | 6.07 | 0.00752 |
| Section 2 | 30 to <40 | 808 | 6.27 | 0.00776 |
| Section 3 | 40 to <50 | 808 | 6.52 | 0.00807 |
| Section 4 | 50 to <60 | 807 | 6.89 | 0.00853 |
| Section 5 | 60 to <70 | 807 | 7.38 | 0.00914 |
| Section 6 | 70 to <80 | 805 | 8.05 | 0.01000 |
| Section 7 | 80 to <90 | 803 | 8.78 | 0.01093 |
| Section 8 | 90 to <100 | 801 | 9.62 | 0.01202 |
| Section 9 | 100 to <110 | 797 | 10.63 | 0.01334 |
| Section 10 | 110 to <120 | 792 | 11.9 | 0.01502 |
| Section 11 | 120 to <130 | 786 | 13.58 | 0.01730 |
| Section 12 | 130 to <140 | 776 | 15.75 | 0.02031 |
| Section 13 | 140 to <150 | 761 | 17.78 | 0.02338 |
| | 30°C | 808 | 6.17 | 0.00764 |
| - | Difference (13th - 1st section) | 46 | 12 | 0.015866 |
| - | Difference (10th - 1st section) | 15 | 6 | 0.007504 |

As observed in Tables 3 through 5, samples in which no damage occurred during the manufacturing process of the packaging substrate showed lower E'20-E'140 (difference between Section 13 and Section 1), particularly when it was 80 MPa or less. This indicates excellent workability of packaging substrates with such properties, likely due to relatively low internal stress differences.

Additionally, samples with relatively high loss modulus values exhibited better workability and impact resistance, suggesting that high loss modulus contributes positively to stress control.

The extreme surface hardness is related to surface strength, which appears to be inversely correlated with flexibility. The difference between Dep-max and Dep-con represents the lateral force exerted on the indenter during indentation, which is associated with stress; it is believed that when this difference is less than 220 nm, minimum workability is ensured.

Furthermore, low standard deviation values from the 10 measurement points suggest that the mechanical characteristics are uniformly distributed across the surface, effectively suppressing localized stress concentration.

Therefore, packaging substrates exhibiting the above-mentioned characteristics may provide enhanced workability, impact resistance, and durability during manufacturing.

Although the preferred embodiments of the present invention have been described in detail above, the scope of the present invention is not limited thereto, and various modifications and improvements made by those skilled in the art based on the basic concept defined in the claims below shall also fall within the scope of the present invention.

## Claims

1. A packaging substrate comprising:
a glass core; a wiring layer; and an insulating layer,
wherein the glass core is a plate-shaped glass in which vias are disposed,
the wiring layer is an electrically conductive layer disposed on a surface of the glass core,
the insulating layer is a layer disposed in a space between the electrically conductive layers and comprises a mixture of a polymer resin and insulating particles,
the packaging substrate has an upper surface on which an electronic device is mounted and a lower surface facing the upper surface,
a measurement point is a point on the surface of the packaging substrate,
ten measurement points, each different from one another, are disposed on the surface,
the measurement points are spaced apart by at least 0.05 times the surface length of the substrate, Er is a value of extreme surface reduced modulus (unit: GPa) measured at the measurement point using a nanoindentation method,
Er_av is an average of the extreme surface reduced modulus values measured at the measurement points,
Er_stdev is a standard deviation of the extreme surface reduced modulus values measured at the measurement points,
the measurement is performed at 27°C,
and a ratio of Er_stdev to Er_av, based on the overall Er_av, is 7% or less.

2. The packaging substrate of claim 1,
wherein Er_av is 20 GPa or less, and
wherein Er_stdev is 1 GPa or less.

3. The packaging substrate of claim 1 or claim 2,
wherein an insulating layer disposed above the glass core is an upper insulating layer,
a cover layer is further disposed on the upper insulating layer,
the cover layer is a polymer resin or an inorganic insulating layer,
the surface is an exposed surface of the cover layer,
and the maximum Er value among the Er values of the cover layer is 16 GPa or less.

4. The packaging substrate of any one of claim 1 to claim 3,
wherein an insulating layer disposed below the glass core is a lower insulating layer,
a solder resist layer is further disposed below the lower insulating layer,
the surface is an exposed surface of the solder resist layer,
and the maximum Er value among the Er values of the solder resist layer is 21 GPa.

5. The packaging substrate of any one of claim 1 to claim 4,
an average storage modulus (E') at a temperature of 20°C to less than 30°C is referred to as E'20, an average storage modulus (E') at a temperature of 140°C to less than 150°C is referred to as E'140, and E'20 - E'140 of the packaging substrate is 80 MPa or less.

6. The packaging substrate of any one of claim 1 to claim 5,
wherein a loss modulus (E") of the packaging substrate at 30°C is 5 MPa or more.

7. The packaging substrate of any one of claim 1 to claim 6,
wherein an extreme surface hardness (HIT), measured at any point on an upper or lower surface of the packaging substrate, is less than 1 GPa.

8. The packaging substrate of any one of claim 1 to claim 7,
wherein a contact compliance of the packaging substrate is 12 nm/mN or less.

9. The packaging substrate of any one of claim 1 to claim 8,
wherein an insulating layer disposed on an upper portion of the glass core is an upper insulating layer,
a cover layer is further disposed on an upper portion of the upper insulating layer,
the cover layer comprises a polymer resin or an insulating inorganic layer,
an insulating layer disposed on a lower portion of the glass core is a lower insulating layer,
a solder resist layer is further disposed below the lower insulating layer, and
extreme surface hardnesses (HITs) of the cover layer and the solder resist layer are both 0.3 GPa or more.

10. The packaging substrate of claim 9,
wherein an extreme surface hardness (HIT) of the solder resist layer is greater than an extreme surface hardness (HIT) of the cover layer.

11. The packaging substrate of claim 9,
wherein an extreme surface hardness (HIT) of the solder resist layer is 0.8 GPa or more.

12. The packaging substrate of any one of claim 1 to claim 11,
wherein a measurement point is a point on a surface of the packaging substrate,
ten distinct measurement points are disposed on the surface,
the measurement points are spaced apart by at least 0.05 times a diameter or diagonal length of the packaging substrate,
HIT is an extreme surface hardness (unit: GPa) measured at the measurement point using a nanoindentation method,
HIT_stdev is a standard deviation of the extreme surface hardness values measured at the measurement points, and
the HIT_stdev is 0.1 GPa or less.

13. The packaging substrate of any one of claim 1 to claim 12,
wherein a difference between the maximum and minimum Er values measured at the respective measurement points is 4 GPa or less.

14. The packaging substrate of any one of claim 1 to claim 13,
wherein the surface is an exposed surface of the insulating layer,
and the maximum Er value among the Er values of the insulating layer is 22 GPa or less.

15. The packaging substrate of any one of claim 1 to claim 14,
wherein a tan delta value of the packaging substrate at 30°C is 0.009 or less.
